# EUROPEAN PATENT SPECIFICATION

(11) **EP 0 413 435 B1**
(45) Date of publication and mention of the grant of the patent: **10.01.1996**
(21) Application number: 90307676.8
(22) Date of filing: 13.07.1990
(51) Int. Cl.: H01L 33/00

(54) **Diamond diode structure**
Diamantdiodenstruktur
Structure de diode diamant

(30) Priority: 13.07.1989 ZA 895334; 23.04.1990 ZA 903054
(43) Date of publication of application: 20.02.1991
(73) Proprietor: DE BEERS INDUSTRIAL DIAMOND DIVISION (PROPRIETARY) LIMITED, Johannesburg, Transvaal (ZA)
(72) Inventor: Prins, Johan Frans, Johannesburg, Transvaal (ZA)
(74) Representative: Senior, Alan Murray

(56) References cited:
- DE-A- 3 818 719
- US-A- 4 277 293
- US-A- 4 571 447
- APPLIED PHYSICS LETTERS, vol. 41, no. 10, November 1982, pages 950-952, New York, US; J.F. PRINS: "Bipolar transistor action in ion implanted diamond"
- NUCLEAR INSTRUMENTS AND METHODS IN PHYSICS RESEARCH, Section B35, nos. 3-4, 2nd December 1988, pages 484-487, Amsterdam, NL; J.F. PRINS: "Improved activation of boron-dopant atoms implanted into diamond"
- PROCEEDINGS OF THE 7TH BIENNAL MICROELECTRONICS SYMPOSIUM, Rochester, 9th - 11th June 1987, pages 187-190; Y. TZENG et al.: "Fabrication and high temperature characteristics of diamond electronic devices"
- SOV. PHYS. DOKL., vol. 21, no. 6, June 1976, pages 298-299, New York, US; V.A. LAPTEV et al.: "Production and study of p-n junctions on synthetic semiconductor diamonds"
- JAPANESE JOURNAL OF APPLIED PHYSICS, vol. 27, no. 2, February 1988, pages L173- L175; K. OKANO et al.: "Synthesis of diamond thin films having semiconductive properties"
- APPLIED PHYSICS LETTERS, vol. 53, no. 19, 7th November 1988, pages 1815-1817; K. HIRABAYASHI et al.: "Selective deposition of diamond crystals by chemical vapor deposition using a tungsten-filament method"
- PATENT ABSTRACTS OF JAPAN, vol. 11 (E-519)[198], 25th June 1987 ; & JP-A-62 024 647

## Description

This invention relates to a method of producing a semiconductor diode in a diamond substrate.

Light emitting diodes (LED's) and junction lasers, which have a diode structure, are useful in optoelectronics applications, and particularly in telecommunications equipment. However, most LED's and junction lasers have been designed to operate at long wavelengths to complement optical fibres and transmission systems which have been optimised for those wavelengths. It is desirable to use short wavelength light (towards the blue end of the spectrum) for high efficiency in optical information transmission, but blue LED's are respectively difficult to produce economically.

"Fabrication and high temperature characteristics of Diamond Electronic Devices", Y Tzeng et al, in Proceedings of the 7th Biennial Microelectronics Symposium Rochester pp. 187-190 discloses the fabrication of semiconductor devices by ion implantation of diamond chips but does not disclose the temperature at which the implantation occurs nor any means to control it.

US-A-4,571,447 discloses the formation of a photovoltaic cell by the implantation of carbon atoms into a type IIb diamond substrate at a temperature of 300°C.

"Improved Activation of Boron-Dopant Atoms implanted into Diamond" by J.F. Prins from Nuclear Instruments and Methods in Physics Research, B 35 (1988) 484-487, discloses a method of doping diamonds to produce semiconductive properties.

According to the present invention there is provided a method of producing a semiconductor diode comprising the steps of providing a p-type diamond substrate; implanting a predetermined dose of ions, neutrons or electrons into the substrate to form an implanted region which defines a p-n junction with the substrate; and applying respective electrical contacts to the substrate and the implanted region, characterised in that the substrate is maintained at a temperature below 50°C during implantation thereof, so that the implanted region is rich in vacancies and interstitials; and by the step of annealing the implanted substrate, thereby causing at least some of the vacancies to form an ordered structure.

In the method, the substrate is maintained at a temperature below about 50°C during implantation thereof. Typically, the substrate is maintained at the temperature of liquid nitrogen.

The substrate is preferably annealed at a temperature above 600°C, typically about 1200°C.

The diamond substrate may comprise a p-type diamond crystal, or a layer of p-type crystalline or polycrystalline diamond formed on a suitable support by a chemical vapour deposition process.

The ions used for implantation of the diamond structure are typically carbon ions.

The substrate may be implanted successively with ions of different energies to promote an even distribution of vacancies and interstitials in the implanted region.

The present invention will be further described hereinafter with reference to the following description of exemplary embodiments and the accompanying drawings in which:
Figure 1 is a schematic illustration of a proposed semiconductor light emitting diode according to the invention;
Figure 2 is a graph illustrating the V/I response or a diode according to the invention;
Figure 3 is a graph comparing the V/I response of two diodes formed according to two variations of the method of the invention;
Figure 4 is a graph comparing the spectral response of the diodes of Figure 3; and
Figure 5 is a schematic illustration of semiconductor diode, used as a photovoltaic cell, according to the invention.

The invention is based on the identification of vacancy clusters or aggregates which form in diamond crystals due to ion implantation. Such ion implantation has been used to create doped layers within a synthetic diamond substrate to create semiconductor devices. The vacancy aggregates are believed to be formed by the clustering of individual vacancies, and act as electron donors. The energy levels of such vacancy aggregates lie within the band gap of the diamond crystal. If, in a p-type diamond crystal, a layer can be created which consists largely or totally of such vacancy aggregates in contact with one another, or even better, comprising an ordered layer of such vacancy aggregates, this region of the crystal will contain an extra electron energy band in the diamond's band-gap. Because the vacancy aggregates are donors, the region will be an n-type region, and will thus form a p-n diode junction with the surrounding p-type diamond substrate.

In one process, a type IIb synthetic diamond substrate is implanted with ions at a temperature at which interstitial atoms, which are released in the damage cascades caused by the ion bombardment, can diffuse, but at which the respective vacancies cannot. This temperature range is from approximately 0°C to 500°C. Interstitial atoms can egress from the vacancy-rich damaged (ion bombarded) region, leaving a highly vacancy-rich region behind. Such vacancies are not mobile, but numerous vacancy aggregates will occur in this region.

The ion dose is critical in obtaining a vacancy-rich region with suitable characteristics. If the ion dosage is too high, the vacancy-rich region may collapse into an amorphous carbon-like state, while if the ion dose is too low, the wave functions of the individual vacancies or vacancy clusters will not overlap sufficiently to provide an efficient system. The ideal ion dose will depend on the ions used for implantation, and the temperature of the diamond substrate being bombarded. In general, the heavier the ions, the lower the ion dose rate would need to be. The higher the temperature of the substrate, the higher the dose would need to be. Because the described effect relies on the intrinsic damage caused to the diamond crystal (that is, the formation of vacancies and their interaction as vacancy aggregates) which is required to obtain the desired result, any ion can be used, provided that it does not interact or interfere with the electrical properties required from the vacancy aggregates. Instead of ions, electrons or neutrons can be used to bombard the substrate.

In the method of the invention, a similar method is employed to that used to dope diamond by ion implantation. However, higher ion doses are applied than would be needed for efficient doping. It is desirable that the diamond be implanted at a low enough temperature (below, say, 50°C and typically at about the temperature of liquid nitrogen) to inhibit the diffusion of both the vacancies and the interstitial atoms resulting from the ion bombardment. After the ion bombardment, the diamond is rapidly heated to an annealing temperature, to enable interstitial vacancy recombination. After annealing, there are always residual vacancies which then cluster to form vacancy aggregates. Once again, the ion dose must not be so high that the diamond reverts to an amorphous graphite-like state. The ion dose and annealing temperature can be optimised to maximise the occurrence of vacancy aggregates in the annealed crystal.

When high ion doses are employed, it is found that the formation of vacancy aggregates is stimulated to such an extent that, in effect, a single layer of vacancy aggregates is obtained. This results in the formation of an n-type region, which forms a p-n junction in the p-type diamond substrate.

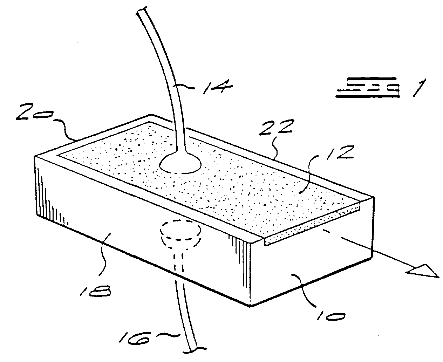

The method of the invention can be used to produce a light emitting diode. As illustrated in Figure 1, a diamond crystal substrate 10 has a vacancy-rich region 12 formed therein, as described above. Contacts 14 and 16 are applied to the vacancy-rich region 12 and to the p-type diamond substrate, and a p-n junction is defined between the substrate 10 and the vacancy-rich region 12. Three sides 18, 20 and 22 of the crystal are polished and silvered, to maximise the intensity of the light emitted.

### Example 1

A small type IIb p-type semiconducting diamond crystal having dimensions of 3mm by 1,5mm by 1mm was first overdoped on one surface with boron by means of ion implantation in order to provide an ohmic electrical contact. The opposite face of the diamond was then implanted with carbon ions at a temperature of 200° C, at the following doses:

**Table 1**

| Energy (keV) | Ion dose per cm |
|---|---|
| 120 | 1,5 x 10¹⁶ |
| 80 | 1,3 x 10¹⁶ |
| 30 | 7,0 x 10¹⁵ |
| 50 | 4,0 x 10¹⁵ |

After implantation, the diamond was boiled in acid to clean it. The boron doped surface was covered with silver paint and the diamond was annealed at 300° C to provide a stable ohmic contact. On the carbon ion-damaged surface, a piece of gold foil was placed, and the diamond was then clamped between the lips of a pair of brass pliers to effect contacts to the two opposite ion implanted faces. It was established that the contact area between the carbon ion damaged region and the rest of the diamond substrate was rectifying, and forward switching could be induced by applying a negative potential to the carbon ion-damaged face relative to the ohmic contact.

When the forward bias applied to the diode was increased, it was observed that blue light was emitted from and along the diode junction. Appreciable light output was obtained with forward bias voltages as low as 10 to 20 volts. In order to measure the spectrum of the light output, the diode was operated in a pulsed mode at high voltages, and an average spectrum obtained. The light output was predominantly blue, with a spectrum peaking at approximately 435 nm.

Experiments have shown that ion implantation of the diamond substrate to sufficiently high doses, but below a dose which causes amorphization, at low temperatures (typically the temperature of liquid nitrogen), followed by annealing at relatively high temperatures (typically well above 600°C), causes the vacancies to diffuse together and to form a crystallographically ordered structure over the whole implanted layer.

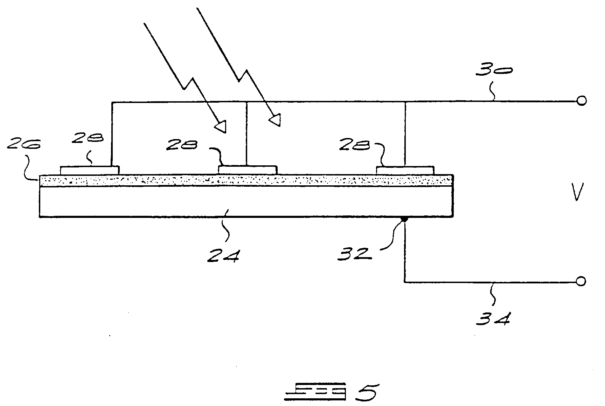

Referring now to Figure 5, a diode structure according to the invention is shown, comprising a conductive substrate 24 with a thin layer 26 of p-type crystalline or polycrystalline diamond deposited thereon by a chemical vapour deposition (CVD) process. The substrate 24 may comprise a layer of metal such as copper or nickel, or may be a layer of doped silicon or silicon carbide. The diamond layer 26 is typically boron doped to provide a p-type substrate. The diamond substrate was implanted with carbon ions, as described below. Metal contacts 28 are attached to the surface of the diamond layer 26 and are all connected to a first conductor 30. A contact 32 is applied to the surface of the conducting substrate 10 and is connected to a second conductor 34.

According to the method of the invention, the diamond substrate 26 on its conductive backing 24 was cooled in an ion implanter to the temperature of liquid nitrogen. At this temperature, the diamond was implanted with carbon ions at ion energies of 150, 110, 80, and 50 keV, to a total ion dose of 6 x 10¹⁵ ions per cm. The dose at each energy level was chosen to promote the formation of an even distribution of vacancies and interstitial in the implanted layer.

After implantation, the diamond was heated rapidly from the temperature of liquid nitrogen to approximately 1000°C, by allowing the diamond to slide into a preheated graphite crucible, inside a quartz tube being flushed with ultra pure Argon gas. After annealing for an hour at this temperature, the implanted layer had a grey to black colour, and was highly conductive. After the diamond's top surface was cleaned with acids, and contacts were attached as shown in Figure 5, the resulting device was found to exhibit strong photovoltaic action.

The thinness which can be obtained with a CVD layer contributes to greater efficiency of the resultant photovoltaic cell. At present, CVD processes can produce diamond layers approximately 50 mm to 75 mm in diameter, which is approximately the size of conventional photovoltaic cells, so that the present technology is clearly applicable to the production of such devices.

In a variation of the invention, a p-type diamond crystal was used as a substrate for implantation instead or a layer deposited by a CVD process. A vacancy-rich region was created in the substrate by ion implantation, as described above, but the diamond was, in this case, rapidly heated to 1200°C. Boiling the implanted diamond in a solution of hydrochloric, perchloric, and nitric acid, which usually removes graphitic layers from the surface of a diamond, did not affect the implanted layer. Furthermore, X-ray diffraction analysis using the grazing angle technique showed that the implanted layer formed by the above described method was not amorphous graphite.

To the rear side of the p-type diamond substrate, an ohmic contact was created by implanting boron ions into the substrate and applying a metallic contact to the implanted area. A further contact was made to the vacancy-rich implanted area by pressing a gold foil against it.

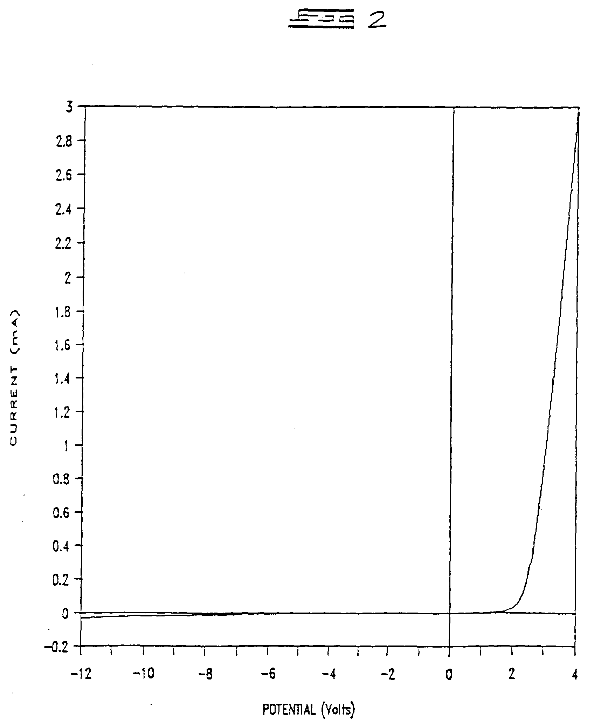

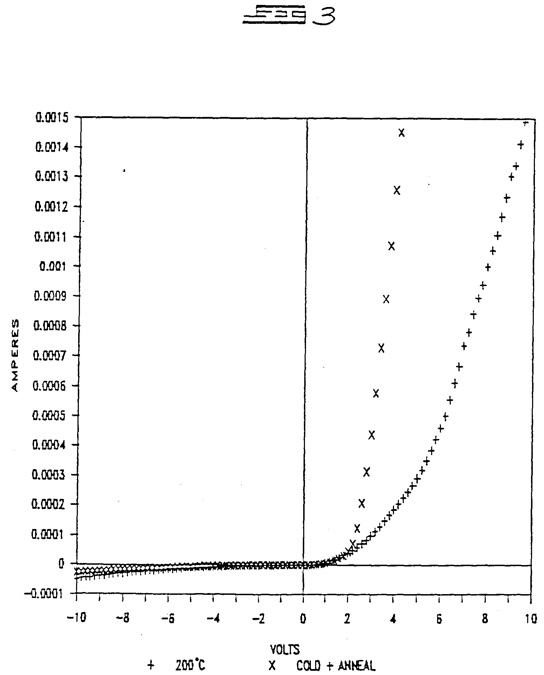

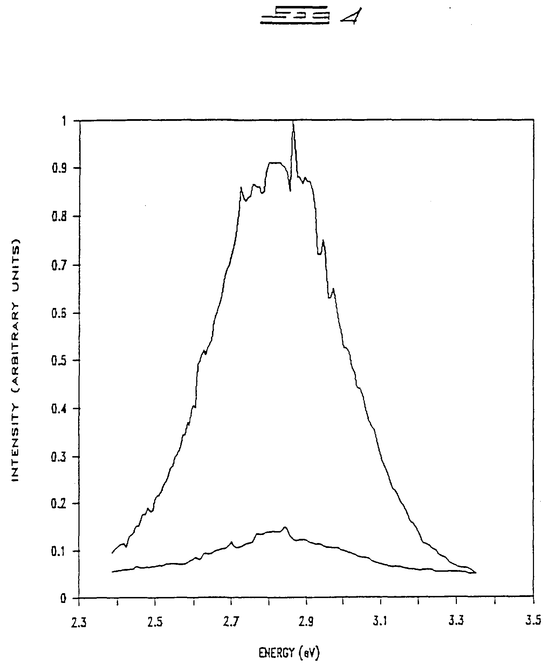

This diode exhibited excellent diode characteristics, with a forward switching voltage of approximately two volts (see Figure 2). Figure 3 shows the characteristics of the above described device compared with those of the device formed by the method set out in Example 1 above. The device formed by ion implantation at low temperature, indicated by the steeper V/I curve, had a substantially lower switching voltage than the diode structure produced by ion implantation at approximately 200°C. Figure 4 shows the comparative light outputs of the above described two diodes, and shows that the diode formed by low temperature ion implantation has a much greater light output, approximately an order of magnitude greater, for a driving voltage approximately 25% of that applied to the other device.

## Claims

1. A method of producing a semiconductor diode comprising the steps of providing a p-type diamond substrate (10, 26); implanting a predetermined dose of ions, neutrons or electrons into the substrate to form an implanted region which defines a p-n junction with the substrate; and applying respective electrical contacts (14, 16; 28, 32) to the substrate and the implanted region, characterised in that the substrate (10; 26) is maintained at a temperature below 50°C during implantation thereof, so that the implanted region is rich in vacancies and interstitials; and by the step of annealing the implanted substrate (10; 26), thereby causing at least some of the vacancies to form an ordered structure.

2. A method according to claim 1 characterised in that the substrate (10; 26) is maintained at about the temperature of liquid nitrogen.

3. A method according to claim 1 or 2 characterised in that the substrate (10; 26) is annealed at a temperature above 600°C.

4. A method according to claim 3 characterised in that the substrate (10; 26) is annealed at about 1200°C.

5. A method according to any one of the preceding claims wherein, in the step of annealing, the substrate is heated rapidly by placing it in a preheated enclosure.

6. A method according to any one of claims 1 to 5 characterised in that the diamond substrate (10) comprises a p-type diamond crystal.

7. A method according to any one of claims 1 to 5 wherein said step of providing a substrate comprises the step of forming a layer (26) of p-type crystalline or polycrystalline diamond by a chemical vapour deposition process on a suitable support (24).

8. A method according to claim 7 characterised in that the diamond layer (26) is boron doped.

9. A method according to claim 7 or claim 8 characterised in that the diamond layer (26) is deposited on a metallic substrate (24).

10. A method according to claim 7 or Claim 8 characterised in that the diamond layer (26) is deposited on a silicon substrate (24).

11. A method according to claim 7 or 8 characterised in that the diamond layer (26) is deposited on a silicon carbide substrate (24).

12. A method according to any one of claims 1 to 11 characterised in that the substrate (10; 26) is implanted with carbon ions.

13. A method according to any one of claims 1 to 12 characterised in that the substrate (10; 26) is implanted successively with ions of different energies to promote an even distribution of vacancies and interstitials in the implanted region.

## Patentansprüche

1. Verfahren zur Herstellung einer Halbleiterdiode, mit den Schritten: Bereitstellen eines p-Diamantsubstrates (10,26); Implantieren einer vorbestimmten Dosis von Ionen, Neutronen oder Elektronen in das Substrat, um einen Implantationsbereich zu bilden, welcher mit dem Substrat einen p-n-Übergang bildet; und Anlegen elektrischer Kontakte (14,16;28,32) jeweils an das Substrat und den Implantationsbereich, gekennzeichnet dadurch,
daß das Substrat (10;26) während der an ihm vorgenommenen Implantation auf einer Temperatur unter 50°C gehalten wird, so daß der Implantationsbereich reich an Gitterlücken und Zwischengitteratomen ist; und durch den Schritt des Ausheizens des mit dem Implantat versehenen Substrates (10;26), wodurch bewirkt wird, daß wenigstens einige der Gitterlükken eine geordnete Struktur bilden.

2. Verfahren nach Anspruch 1, dadurch gekennzeichnet, daß das Substrat (10;26) auf etwa der Temperatur von flüssigem Stickstoff gehalten wird.

3. Verfahren nach Anspruch 1 oder 2, dadurch gekennzeichnet, daß das Substrat (10;26) bei einer Temperatur über 600°C ausgeheizt wird.

4. Verfahren nach Anspruch 3, dadurch gekennzeichnet, daß das Substrat (10;26) bei ungefähr 1200°C ausgeheizt wird.

5. Verfahren nach einem der vorhergehenden Ansprüche, bei dem das Substrat in dem Schritt des Ausheizens schnell erwärmt wird, indem es in einem vorgewärmten Gehäuse angeordnet wird.

6. Verfahren nach einem der Ansprüche 1 bis 5, dadurch gekennzeichnet, daß das Diamantsubstrat (10) einen p-Diamantkristall aufweist.

7. Verfahren nach einem der Ansprüche 1 bis 5, bei dem der Schritt des Bereitstellens eines Substrates den Schritt des Bildens einer Schicht (26) aus kristallinem oder polykristallinem p-Diamant mittels eines Chemical-Vapour-Deposition-Verfahrens auf einem geeigneten Träger (24) aufweist.

8. Verfahren nach Anspruch 7, dadurch gekennzeichnet, daß die Diamantschicht (26) bordotiert wird.

9. Verfahren nach Anspruch 7 oder Anspruch 8, dadurch gekennzeichnet, daß die Diamantschicht (26) auf einem metallischen Substrat (24) aufgebracht wird.

10. Verfahren nach Anspruch 7 oder Anspruch 8, dadurch gekennzeichnet, daß die Diamantschicht (26) auf einem Siliziumsubstrat (24) aufgebracht wird.

11. Verfahren nach Anspruch 7 oder 8, dadurch gekennzeichnet, daß die Diamantschicht (26) auf einem Siliziumkarbidsubstrat (24) aufgebracht wird.

12. Verfahren nach einem der Ansprüche 1 bis 11, dadurch gekennzeichnet, daß in das Substrat (10;26) Kohlenstoffionen implantiert werden.

13. Verfahren nach einem der Ansprüche 1 bis 12, dadurch gekennzeichnet, daß in das Substrat (10;26) nacheinander Ionen unterschiedlicher Energien implantiert werden, um eine gleichmäßige Verteilung der Gitterlücken und Zwischengitteratome in dem Implantationsbereich zu fördern.

## Revendications

1. Procédé pour produire une diode à semiconducteur comprenant les étapes consistant en la fourniture d'un substrat en diamant de type p (10, 26); l'implantation d'une dose prédéterminée d'ions, neutrons ou électrons dans le substrat pour former une région implantée qui définit une jonction p-n avec le substrat; et l'application de contacts électriques respectifs (14, 16; 28, 32) sur le substrat et la région implantée, caractérisé en ce que le substrat (10; 26) est maintenu à une température inférieure à 50°C pendant son implantation, de manière que la région implantée soit riche en lacunes et en interstitiels; et par l'étape consistant à recuire le substrat implanté (10; 26), amenant ainsi certaines au moins des lacunes à former une structure ordonnée.

2. Procédé selon la revendication 1, caractérisé en ce que le substrat (10; 26) est maintenu environ à la température de l'azote liquide.

3. Procédé selon la revendication 1 ou 2, caractérisé en ce que le substrat (10; 26) est recuit à une température supérieure à 600°C.

4. Procédé selon la revendication 3, caractérisé en ce que le substrat (10; 26) est recuit à environ 1200°C.

5. Procédé selon l'une quelconque des revendications précédentes, dans lequel, au cours de l'étape de recuit, le substrat est chauffé rapidement en le plaçant dans une enceinte préchauffée.

6. Procédé selon l'une quelconque des revendications 1 à 5, caractérisé en ce que le substrat en diamant (10) comprend un cristal de diamant de type p.

7. Procédé selon l'une quelconque des revendications 1 à 5, dans lequel ladite étape consistant à fournir un substrat comprend l'étape consistant à former une couche (26) en diamant cristallin ou polycristallin de type p par un procédé chimique de dépôt en phase gazeuse sur un support approprié (24).

8. Procédé selon la revendication 7, caractérisé en ce que la couche de diamant (26) est dopée au bore.

9. Procédé selon la revendication 7 ou la revendication 8, caractérisé en ce que la couche de diamant (26) est déposée sur un substrat métallique (24).

10. Procédé selon la revendication 7 ou la revendication 8, caractérisé en ce que la couche de diamant (26) est déposée sur un substrat en silicium (24).

11. Procédé selon la revendication 7 ou 8, caractérisé en ce que la couche de diamant (26) est déposée sur un substrat en carbure de silicium (24).

12. Procédé selon l'une quelconque des revendications 1 à 11, caractérisé en ce que le substrat (10; 26) est implanté avec des ions carbone.

13. Procédé selon l'une quelconque des revendications 1 à 12, caractérisé en ce que le substrat (10; 26) est successivement implanté avec des ions d'énergies différentes pour favoriser une distribution régulière de lacunes et d'interstitiels dans la région implantée.
